Europäisches Patentamt

European Patent Office

Office européen des brevets

(11) Publication number: **0 149 403**
**A2**

(12) **EUROPEAN PATENT APPLICATION**

(21) Application number: **84402759.9**

(22) Date of filing: **28.12.84**

(51) Int. Cl.⁴: **G 11 C 7/00**
**G 11 C 11/40**

(30) Priority: **28.12.83 JP 249221/83**

(43) Date of publication of application:
**24.07.85 Bulletin 85/30**

(84) Designated Contracting States:
**DE FR GB**

(71) Applicant: **FUJITSU LIMITED**
**1015, Kamikodanaka Nakahara-ku**
**Kawasaki-shi Kanagawa 211(JP)**

(72) Inventor: **Seki, Teruo**
**5-2-5, Shimo-Shinjo 3-chome**
**Nakahara-ku, Kawasaki-shi, Kanagawa 211(JP)**

(72) Inventor: **Aoyama, Keizo**
**11-28, Tsukimino 1-chome**
**Yamato-shi Kanagawa 242(JP)**

(74) Representative: **Descourtieux, Philippe et al,**
**CABINET BEAU de LOMENIE 55 rue d'Amsterdam**
**F-75008 Paris(FR)**

(54) **Sense amplifier for static MOS memory.**

(57) A sense amplifier for a circuit having a complementary output, such as a static MOS memory device, has a clamping means (Q₇, Q₈) connected between the output terminals (OUT1, OUT2) of the sense amplifier. The clamping means clamps the differential output voltage to a value which is sufficiently low to reduce the time delay of the output signal, in order to obtain a high switching rate of the sense amplifier, but still sufficient to keep the output voltage at the level necessary to operate a subsequent circuit of the device.

FIG.4

SENSE AMPLIFIER FOR STATIC MOS MEMORY

BACKGROUND OF THE INVENTION

The present invention relates to a sense amplifier for a circuit having a complementary output, such as a sense amplifier arranged in a peripheral circuit of a static MOS (metal oxide semiconductor) memory. More particularly, it relates to a sense amplifier comprising a differential amplifier and having a quick response to an input signal with a high switching rate.

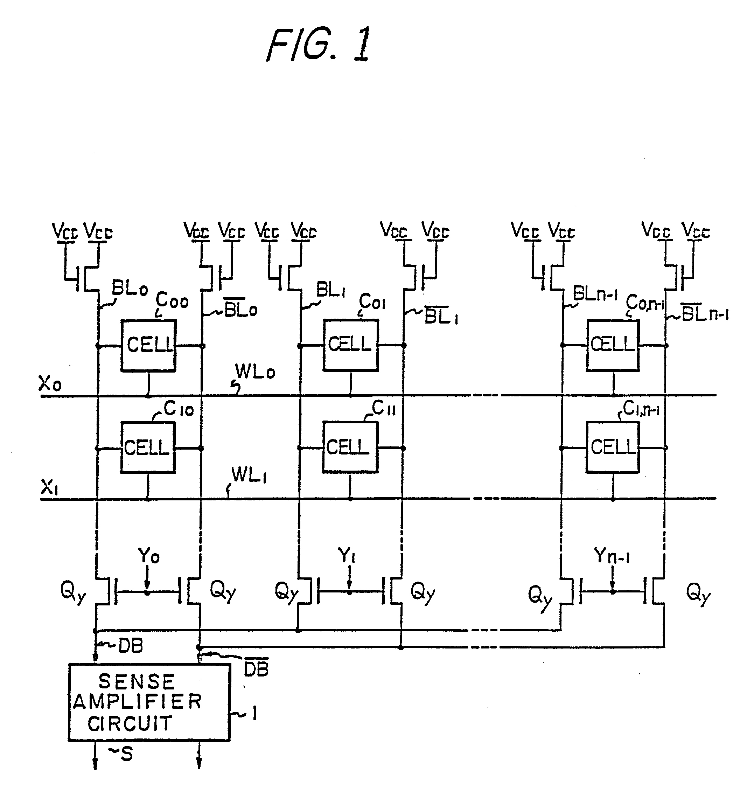

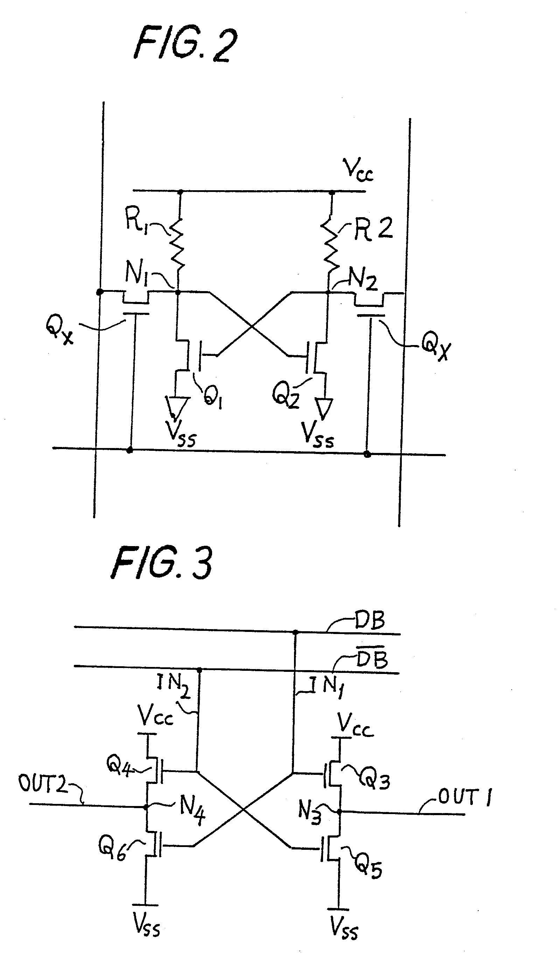

As shown partially in the circuit diagram of Fig. 1, a static memory device formed on a silicon chip (substrate) comprises an array of memory cells having n rows and n columns and associated peripheral circuits such as row decoders (not shown), column decoders (not shown) and sense amplifiers. When a memory cell $C_{11}$ in the 1st row and 1st column, for example, is selected, the potential of a row select signal $X_1$, accordingly the potential at a word line $WL_1$, is changed from low to high by a row decoder (not shown) and the potential of a column select signal $Y_1$ is changed from low to high by a column decoder (not shown). Accordingly FETs $Q_x$ (shown in Fig. 2) and $Q_y$ at 1st row and 1st column become conductive and the output of the memory cell $C_{11}$ is fed to a sense amplifier S through bit lines $BL_1$ and $\overline{BL}_1$, and data bus lines DB and $\overline{DB}$.

Fig. 2 is a circuit diagram illustrating a memory cell in the memory array. The storage elements of the memory cell are MOS (metal-oxide-semiconductor) FETs (field effect transistors) and resistors. The memory cell comprises resistors $R_1$ and $R_2$ and transistors $Q_1$ and $Q_2$, forming two inverters $R_1$-$Q_1$ and $R_2$-$Q_2$, respectively, which are cross-coupled so as to operate as a flip-flop. Each inverter has a node (node $N_1$ and node $N_2$ as shown in Fig. 2), to which the transistors and the resistors of the inverters are connected. A combination of the potential of these nodes, namely high level and low level or vice versa, corresponds to the state "1" and another combination corresponds to the state "0".

For example, the combination of a low potential at node $N_1$ and of a high potential at node $N_2$ is assumed to correspond to the state "0". The MOS transistor $Q_1$ is conductive and a current flows across $R_1$-$Q_1$ inverter, and the power supply voltage Vcc is dropped by the resistor $R_1$, so that the potential at the node $N_1$ is

at the low level, while the MOS transistor $Q_2$ is non-conductive and no current flows across $R_2$–$Q_2$ inverter, so that a high level potential is applied to the node $N_2$. Thus, the memory cell is a bistable circuit having a flip-flop operation. The different potentials at node $N_1$ and node $N_2$ are fed to the sense amplifier S as described above, and the information stored in the cell is read out.

Writing is accomplished by forcing the bit-lines to the value desired in the memory cells C, thereby overriding the contents of the memory cells C.

Generally, the differential component of the output potential of the memory cells is held at a relatively low level so as to obtain a high switching rate of the flip-flop operation of the memory cell. The low level differential component of the signal is approximately 0.5 V, for instance. However, in a logic circuit, such as a TTL (transistor-transistor logic) inverter for a computer, a higher potential level is necessary, such as approximately 2 V. Therefore, the output of the memory cells at the MOS level is fed to the sense amplifier to be amplified to the TTL level.

Fig. 3 is a circuit diagram of a prior art sense amplifier S comprising two FETs $Q_3$, $Q_5$ and two FETs $Q_4$, $Q_6$ whose gates are cross-connected as shown in the figure. The input signals are fed from the memory cell array through data bus lines DB and $\overline{DB}$ to the input terminals IN1 and IN2, respectively. When the signal fed to the input terminal IN1 is at a high level and that fed to the input terminal IN2 is at a low level, the transistors $Q_3$ and $Q_6$ are conductive and the transistors $Q_4$ and $Q_5$ are non-conductive. As a result, the potential of the output terminal OUT1 is approximately equal to the power supply voltage Vcc and that of the output terminal OUT2 is approximately equal to that of a second power supply voltage Vss, usually ground potential. Thus the input signals are amplified to TTL level and fed to a subsequent circuit.

However, in such a prior art sense amplifier circuit, the sensing rate is low due to the relatively high output current of the sense amplifier and to associated parasitic capacitors. Recently, significant improvements have been made regarding the time delay of the memory cells and the readout rate of the memory device becomes limited by the switching rate of the sense amplifier. In order to improve the switching rate, a sense amplifier having a positive feedback system has been proposed and reported in an article WAM 1.3, ISCC Report, February 18, 1981 by HITACHI Co. The positive feedback is performed by capacitors each of which is connected between an output terminal and the input terminal of the counter side to form a cross-coupled wiring. Actually, this sense amplifier has a reduced time delay, but the use of capacitors is undesirable for a semiconductor device because capacitors occupy a significantly large area on its substrate, reducing the packaging density of the device.

SUMMARY OF THE INVENTION

It is an object of the present invention to provide a memory device with a sense amplifier having a high switching rate without the need of a feedback system using capacitors.

This object is attained by an improved sense amplifier comprising a differential amplifier having a pair of output terminals and wherein, according to the invention, clamping means are provided between said output terminals for clamping the voltage between said output terminals to a value determined by said clamping means.

The object of the clamping means is to reduce the time delay, compared with the prior art devices, by allowing a limited discharging current flow between the output terminals.

The voltage clamped between the output terminals has a predetermined value, which is lower than that in the prior art devices which have no clamping means, but sufficient for driving the subsequent circuits of the device.

According to a particular embodiment of the invention, the clamping means has a pair of FETs connected between the outpout terminals with the gate electrodes of each FET commonly connected to the drain region of the same FET, the FETs being connected in parallel but in opposite directions.

By the aid of the clamping means, the output current of the sense amplifier is reduced, resulting in the decrease in the charging or discharging time through the transistors included in the sense amplifier. This contributes to provide the sense amplifier

4

0149403

with a higher switching rate.

These and other objects and features of the invention will be more readily understood from the following detailed description when taken in conjunction with the accompanying drawings.

## BRIEF DESCRIPTION OF THE DRAWINGS

Fig. 1 is a partial block circuit diagram of a static MOS memory device illustrating the wiring of its memory matrix array and a sense amplifier;

Fig. 2 is a circuit diagram of a memory cell comprising two resistors and two transistors formed on a substrate;

Fig. 3 is a circuit diagram of a prior art sense amplifier for a static MOS memory device;

Fig. 4 is a circuit diagram of a sense amplifier according to the present invention for a static MOS memory device;

Fig. 5 shows time charts illustrating the time delay between the output signals and the input signals of a sense amplifier, for comparing the time delay of a sense amplifier according to input with that of a prior art sense amplifier; and

Fig. 6 is a wiring diagram of a modified clamping means for a higher clamping voltage.

## DESCRIPTION OF THE PREFERRED EMBODIMENTS

Same reference characters refer to same or similar parts throughout the drawings.

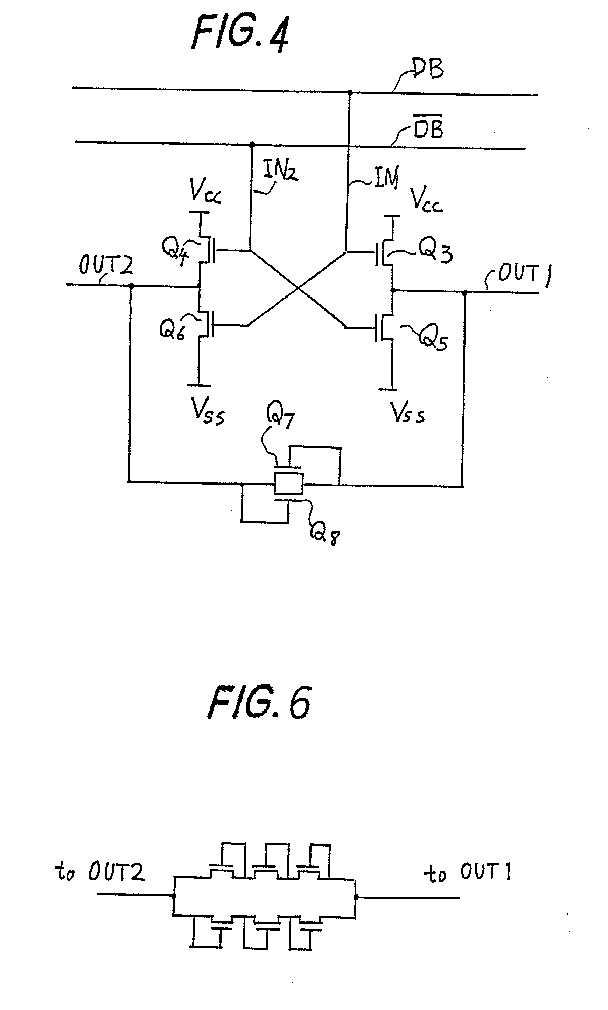

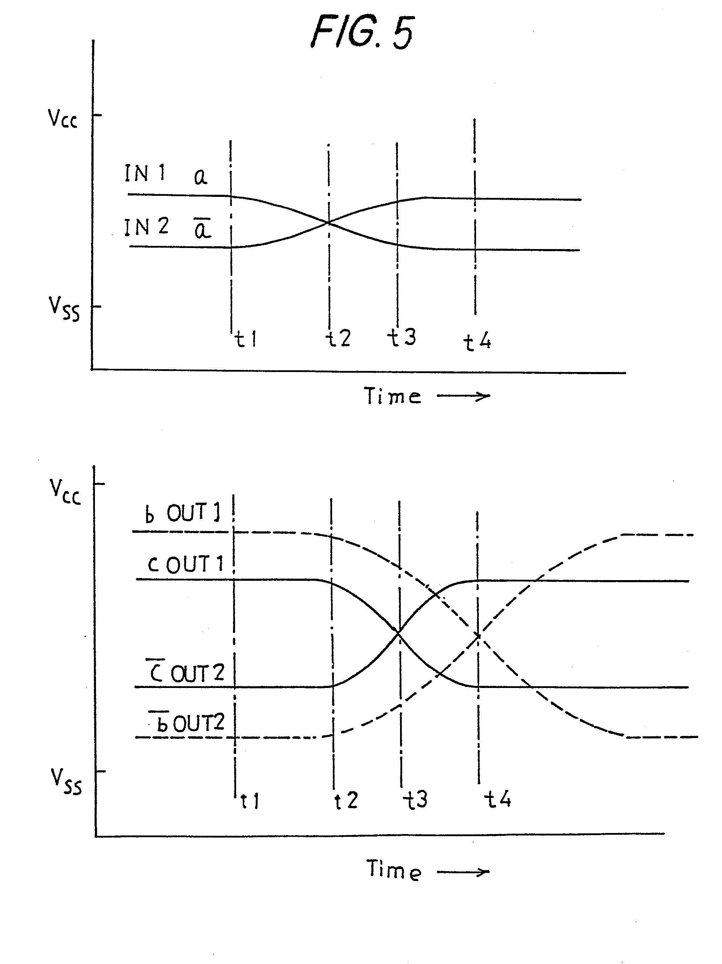

The circuit and operation of a sense amplifier according to the present invention will be discussed comparing with that of a prior art one, with reference to Fig. 4 and 5. Fig. 4 is a circuit diagram of the sense amplifier according to the present invention and Fig. 5 shows time charts, wherein the changes with time of the input and output signals of the sense amplifiers shown in Fig. 3 and 4 are illustrated. The potentials Vcc and Vss are marked at the left hand margin of Fig. 5 for reference.

Briefly speaking, according to the invention, a clamping means is connected between two output terminals OUT1 and OUT2 of the sense amplifier. As shown in Fig. 4, a pair of enhanced n

type FETs $Q_7$ and $Q_8$ is wired between the output terminals OUT1 and OUT2. The two transistors are connected in parallel and the gate of each transistor is commonly connected to the drain region of the same transistor. The transistors are wired in parallel to each other but in opposite directions with the commonly connected nodes being on opposite sides of the clamping means, as shown in Fig. 4. Accordingly, when the potential of the output terminal OUT1 is at a high level, the transistor $Q_7$ is conductive as long as the potential difference between the potentials of the output terminals OUT1 and OUT2 is higher than the threshold voltage of the transistor $Q_7$, and vice versa. If the potential difference falls below the threshold voltage of the transistors $Q_7$ and $Q_8$, these transistors become non-conductive. Therefore, the thus wired transistors $Q_7$ and $Q_8$ can release the charge of the output terminal at high potential to the other output terminal at low potential and secure a minimum value of the potential difference between the two output terminals higher than the threshold voltage. Thus, the pair of transistors $Q_7$, $Q_8$ acts as a clamping means.

The relation between the input and output signals of the prior art sense amplifier shown in Fig. 3 and that of the sense amplifier according to the present invention shown in Fig. 4 will be now discussed referring to the time charts of Fig. 5. The curves a and $\overline{a}$ signified IN1 and IN2 show the input signals to the sense amplifiers during a switching operation. The output singals of the priort art sense amplifier having no clamping means are shown by dotted curves b and $\overline{b}$ signified OUT1 and OUT2, showing a relatively large time delay with respect to the input signals. The output signals of the improved sens amplifier according to the present invention are shown by the curves c and $\overline{c}$ signified OUT1 and OUT2.

As it is apparent, the time delay is reduced to a smaller value in the sense amplifier of the invention. For convenience, the time delay will be defined by the time length from the starting time point $t_1$ of the switching operation at the input to the crossing time point where the two input signals or the two output signals take the same potential value. As shown in Fig. 5, crossing time points for the input signals, the output signals of the prior art sense amplifier and the output signals of the improved sense amplifier according to the present invention are respectively $t_2$, $t_3$ and $t_4$. Of course, the input signals themselves have a time delay due to the associated elements and wirings. Accordingly, the time delays of the two pairs of output signals shown by the curves b, $\bar{b}$, c and $\bar{c}$ can be represented by the time lengths $t_2$-$t_4$ and $t_2$-$t_3$, which may be respectively of 8~10 ns and 4~5 ns.

The course of the time delay of the prior art sense amplifier of Fig. 3 is considered as follows. When, at $t_1$, the input signals are switched and the potential at each input terminal starts ascending or descending, currents flow through circuits $Q_4$-$Q_6$ and $Q_3$-$Q_5$. In addition, the electric charges charged in associated parasitic capacitors also flow through the transistors $Q_5$ and $Q_6$. The conductance of the transistors $Q_5$ and $Q_6$ is relatively low during the transient time when the switching operation is performed and enhances the above-mentioned time delay. After the switching has started and the input signals have shown some change of potential, the output signals will not vary for a certain time length, as if the output signals were held up, until the time point $t_2$ where the output signals start to change. Thus the output signals respond to the input signals with a relatively long delay as shown by the curves b and $\bar{b}$. This is because a time period is necessary to release the electric charges from the output terminal OUT1 through the transistor $Q_5$ and to charge up the output terminal OUT2 through the transistor $Q_4$. Apparently, this time period depends on the conductance of the transistors, and, more sensitively, on the quantity of the electric charges to be released. The quantity of the charges is proportional to the potential. Therefore, the above mentioned time delay will be reduced by decreasing the potential difference between the output terminals while keeping a minimum potential difference necessary to drive the subsequent circuit.

In the sense amplifier according to the present invention having a clamping means connected between the output terminals, as shown in Fig. 4, a charge current flows through the FET $Q_7$ causing a reduction of the potential at the output terminal OUT1, as shown by the curve c, and an increase of the potential at the output terminal OUT2, as shown by the curve $\bar{c}$, resulting in a reduction of the potential difference between the output terminals. A thus clamped potential difference causes a smaller quantity of charges to be stored in the circuit. As a result, the time delay of the output signals is significantly reduced as shown in Fig. 5.

In the sense amplifier S shown in Fig. 4, the conductance of the FETs $Q_7$ and $Q_8$ should be selected smaller than those of the FETs $Q_3$, $Q_4$, $Q_5$ and $Q_6$. Otherwise, the difference between the output voltages would fall down below the threshold voltage of the clamping transistors $Q_7$ and $Q_8$, providing an insufficient output voltage to drive a subsequent circuit. The minimum clamping voltage is determined by the threshold voltage of the clamping FETs, as described before. Accordingly, as shown in Fig. 6, a higher minimum clamping voltage can be obtained by providing clamping means in the form of two series of FETs, the FETs being serially connected in each series, and the series being connected in parallel between the output terminals OUT1 and OUT2. Furthermore, since the clamping means includes FETs, the area occupied by the clamping means is significantly smaller that the one which would be necessary with other electrical elements such as capacitors, contributing to a higher packing density on the substrate. In addition, the clamping means being formed of FETs, it does not require any additional fabricating step, resulting in no fabrication cost increase.

Though the clamping means of the above described sense amplifier comprises FETs, the present invention is not limited to this embodiment. It will be understood by those skilled in the art that other electrical elements such as bipolar transistors, diodes and the like can also be used for the clamping means.

8  0149403

CLAIMS

1.      A sense amplifier (S) for a circuit having a complementary output comprising :

a differential amplifier ($Q_3$-$Q_6$) having a pair of output terminals (OUT1, OUT2); and

a clamping means ($Q_7$, $Q_8$) connected between said output terminals for clamping the voltage between said output terminals to a value determined by said clamping means.

2.      A sense amplifier of claim 1, wherein said clamping means comprises two field effect transistors or FETs ($Q_7$, $Q_8$) or two series of FETs (Fig. 6) connected in parallel between said output terminals, each of the FETs having a gate electrode commonly connected to the drain region of said FET, and the two FETs or two series of FETs being connected in opposite direction.

FIG. 1

1/4

0149403

## FIG.2

## FIG.3

## FIG.4

## FIG.6

# FIG. 5